# EUROPEAN PATENT APPLICATION

(11) **EP 4 696 820 A1**
(43) Date of publication of application: **18.02.2026**
(21) Application number: 24220251.3
(22) Date of filing: 16.12.2024
(51) Int. Cl.: C30B 23/06, C30B 29/36

(54) **SYSTEM AND METHOD FOR CONTROLLING SILICON CARBIDE CRYSTAL GROWTH**

(30) Priority: 15.08.2024 US 202418806006
(71) Applicant: Semiconductor Components Industries, LLC, Scottsdale, AZ 85250 (US)
(72) Inventor: MACKO, Rastislav, 06601 Humenne, Presovsky kraj (SK); VALEK, Lukas, 75661 Stritez nad Becvou (CZ); HYBL, Jan, Zubri (CZ)
(74) Representative: Manitz Finsterwald Patent- und Rechtsanwaltspartnerschaft mbB

(57) **Abstract**

A growth system is disclosed. The growth system may include a crucible at least partially enclosed by an insulation layer, a growth region located within the crucible and configured to hold a silicon carbide (SiC) seed crystal, a source-material region located within the crucible and configured to hold an SiC source material. The growth system may further include a barrier located within the crucible and configured to separate the source-material region and the growth region. In addition, the growth system may include a heating element located around the crucible and configured together with an opening in the insulation layer to provide a temperature gradient with a decreasing temperature in a direction from the source material toward the growth region. The growth system may also include a vent extending through the barrier from the source-material region to the growth region.

## Description

### TECHNICAL FIELD

The disclosure relates generally to silicon carbide (SiC) crystal growth, and particularly to the growth of an SiC crystal in a physical vapor transport system.

### BACKGROUND

Silicon carbide (SiC) is a semiconductor material that may be used in certain applications due to its physical and electrical characteristics. SiC wafers are used to create SiC devices such as SiC-based metal-oxide semiconductor field-effect transistors (MOSFETs). SiC wafers may be produced by cutting a disc shaped SiC substrate from an SiC monocrystal. Such SiC monocrystals may be grown through a physical vapor transport (PVT) process.

In traditional PVT processes, an SiC source powder may be heated to provide a vapor through sublimation. The vapor may then deposit onto an SiC seed crystal to grow the SiC monocrystal. In traditional PVT processes, the SiC source powder may be encapsulated by a membrane of porous graphite. The inventors of embodiments of the present disclosure have recognized that such a porous graphite material may be brittle and may thus create challenges in the manufacturing environment. The inventors of embodiments of the present disclosure have also recognized that traditional PVT processes may be slow and that controlling the growth rate of the SiC monocrystal may be beneficial to production capacity. Embodiments of the present disclosure may address one or more of these challenges.

### BRIEF DESCRIPTION OF THE DRAWINGS

A more complete understanding of the present embodiments may be acquired by referring to the following description taken in conjunction with the accompanying drawings, in which like reference numbers indicate like features.
FIG. 1A illustrates a side cross-sectional view of a crystal growth system in accordance with embodiments of the present disclosure.
FIG. 1B illustrates a top view of a crystal growth system in accordance with embodiments of the present disclosure.
FIG. 1C illustrates a top view of a crystal growth system in accordance with embodiments of the present disclosure.
FIG. 2 illustrates a side cross-sectional view of a crystal growth system in accordance with embodiments of the present disclosure.
FIG. 3 illustrates a side cross-sectional view of a crystal growth system in accordance with embodiments of the present disclosure.
FIG. 4 illustrates a side cross-sectional view of a crystal growth system in accordance with embodiments of the present disclosure.
FIG. 5 illustrates a side cross-sectional view of a crystal growth system in accordance with embodiments of the present disclosure.
FIG. 6 illustrates a side cross-sectional view of a crystal growth system in accordance with embodiments of the present disclosure.
FIG. 7 illustrates a side cross-sectional view of a crystal growth system in accordance with embodiments of the present disclosure.
FIG. 8 illustrates a side cross-sectional view of a crystal growth system in accordance with embodiments of the present disclosure.
FIG. 9 illustrates a side cross-sectional view of a crystal growth system in accordance with embodiments of the present disclosure.
FIG. 10A illustrates a side cross-sectional view of a crystal growth system in accordance with embodiments of the present disclosure.
FIG. 10B illustrates a top view of a crystal growth system in accordance with embodiments of the present disclosure.
FIG. 10C illustrates a top view of a crystal growth system in accordance with embodiments of the present disclosure.
FIG. 10D illustrates a top view of a crystal growth system in accordance with embodiments of the present disclosure.
FIG. 10E illustrates a top view of a crystal growth system in accordance with embodiments of the present disclosure.
FIG. 11 illustrates a method for growing an SiC crystal in accordance with embodiments of the present disclosure.

### DETAILED DESCRIPTION

Details of one or more embodiments are set forth in the description below and the accompanying drawings. Other features will be apparent from the description, drawings, and from the claims.

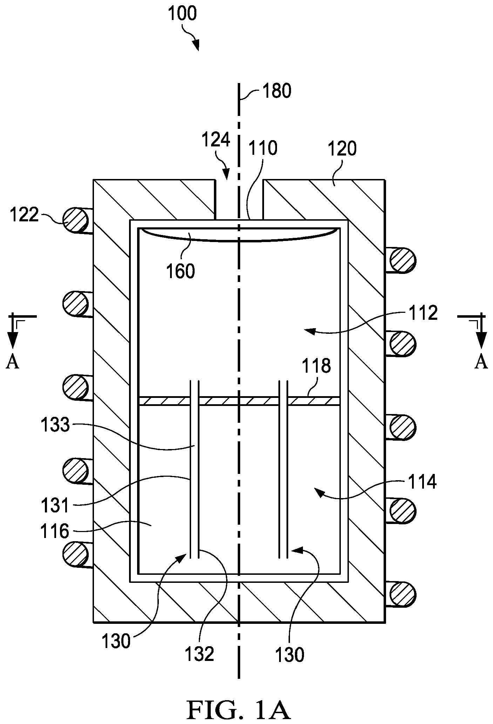

FIG. 1A illustrates a side cross-sectional view of crystal growth system 100 in accordance with embodiments of the present disclosure. Crystal growth system 100 may include crucible 110, growth region 112, source-material region 114, barrier 118, insulation layer 120, heating element 122, opening 124, and vent 130.

In some embodiments, crucible 110 may have a cylindrical shape. Crucible 110 may be at least partially surrounded enclosed by insulation layer 120. For example, insulation layer 120 may surround crucible 110 with the exception of opening 124 that may be located on the top side of crucible 110. In some embodiments, opening 124 may be utilized as a viewport for a pyrometer (not shown in FIG. 1 A) located at the top of the growth furnace to monitor the temperate of crucible 110. Opening 124 may, together with heating element 122, provide a temperature gradient with a decreasing temperature from source-material region 114 toward opening 124. For example, heating element 122 may be configured to heat the contents of crucible 110, including SiC source material 116 within source-material region 114. In some embodiments, heating element 122 may be implemented by an RF heating coil. Opening 124 may provide a cooling path through insulation layer 120, and thus together with heating element 122, may generate a temperature gradient within crucible 110 with a decreasing temperature in the direction from source-material region 114 toward growth region 112, the top of which may be adjacent to opening 124.

Growth region 112 may be located within crucible 110. For example, growth region 112 may be located within an upper portion of crucible 110 adjacent to opening 124. Further, growth region 112 may be configured to hold a silicon carbide (SiC) seed crystal 160. As described in further detail below, the SiC monocrystal may be grown using SiC seed crystal 160 as a seed for the monocrystal growth in a PVT process.

Source-material region 114 may be located within crucible 110. For example, source-material region may be located within a lower portion of crucible 110 opposite to opening 124. Source-material region 114 may be configured to hold SiC source material 116. In some embodiments, SiC source material 116 may be an SiC source powder. When heated by heating element 122, SiC source material 116 may turn into a vapor that may deposit onto the SiC seed crystal 160 to grow an SiC monocrystal.

Barrier 118 may be located within crucible 110 and may be configured to separate source-material region 114 from growth region 112. For example, barrier 118 together with a sidewall of crucible 110 may encapsulate the SiC source material 116 located within source-material region 114. Barrier 118 may be implemented in any suitable fashion according to the operation described in the present disclosure. For example, in some embodiments, barrier 118 may comprise a layer of porous graphite. And in some embodiments, barrier 118 may alternatively or additionally comprise a layer of isostatic graphite or other suitable material.

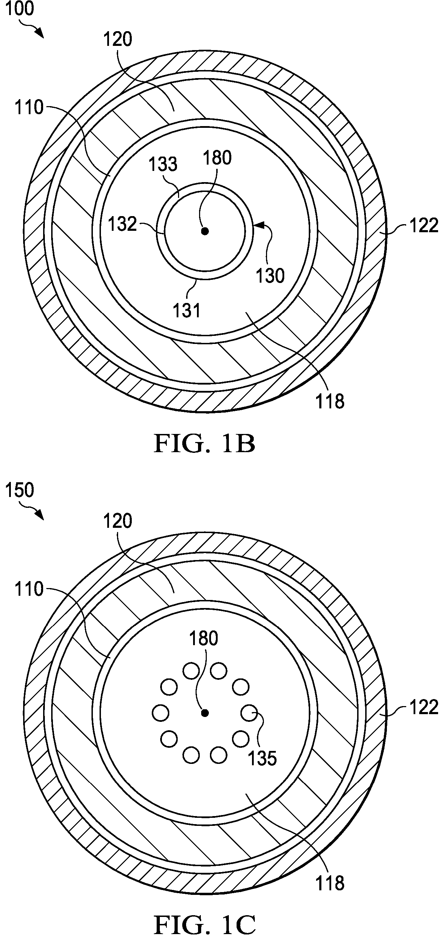

FIG. 1B illustrates a top view of crystal growth system 100 in accordance with embodiments of the present disclosure. In particular, FIG. 1B illustrates a top view of crystal growth system 100 from the perspective of cutline A shown FIG. 1A.

As shown in FIG. 1A and FIG. 1B, crystal growth system 100 may also include vent 130. Vent 130 may be implemented in any suitable fashion according to the operation described in the present disclosure. Vent 130 may have an internal space 133 defined between outer sidewall 131 and inner sidewall 132. Inner sidewall 132 may have a first cylindrical shape centered around the center axis 180 of crucible 110. Outer sidewall 131 may have a second cylindrical shape centered around the center axis 180 of crucible 110. As shown by the side cross-sectional view of FIG. 1A together with the top view of FIG. 1B, the first cylindrical shape of inner sidewall 132 may have a first diameter smaller than a second diameter of the second cylindrical shape of outer sidewall 131.

During crystal growth, heating element 122 may heat the contents of crucible 110, including the SiC source material 116 contained within source-material region 114. When heated, sublimation may occur and the SiC source material 116 may transition from a solid form to a vapor. As described above, heating element 122 together with the cooling path formed by opening 124 in insulation layer 120 may provide a temperature gradient with a decreasing temperature in the direction from source-material region 114 to growth region 112. The vapor may travel from areas of higher temperature to areas of lower temperature, for example from source-material region 114 toward SiC seed crystal 160.

As described above, in some embodiments, barrier 118 may be implemented with a layer of porous graphite material. In such embodiments, the vaporized source material may traverse the pores of the porous graphite material of barrier 118 to enter growth region 112. The inventors of embodiments of the present disclosure have recognized that increasing the rate at which vaporized source material may reach growth region 112, and specifically the SiC seed crystal 160, may increase the rate of the SiC crystal growth.

As shown in FIG. 1A, vent 130 may serve as alternative or additional pathway for the vapor to travel from source-material region 114 to growth region 112, and ultimately to SiC seed crystal 160. Specifically, vent 130 may serve as an exhaust path for the vaporized source material to exit source-material region 114 on its way toward SiC seed crystal 160 within growth region 112. As described above, heating element 122 together with the cooling path formed by the opening 124 in insulation layer 120 may generate a temperature gradient with a decreasing temperature in the direction from source-material region 114 to growth region 112. The internal space 133 within vent 130 may thus also include a temperature gradient from a first end of vent 130 located in source-material region 114 toward a second end located in (or adjacent to) growth region 112. The temperature gradient within vent 130 may thus provide a driving force to transport the vapor from source-material region 114 to growth region 112.

The dimensions and number of vents, such as vent 130, may be utilized to control the rate of SiC crystal growth. For example, increasing the venting area, whether by increasing the number of vents or by increasing the size of the internal space 133 of vent 130, may increase the amount of vapor flowing through such vents and toward SiC seed crystal 160. As another example, increasing the length of one or more vents such as vent 130 may result in a greater total temperature gradient from a first end of the vent located in source-material region 114 to the opposite end located in (or adjacent to) growth region 112. The greater total temperature gradient may in turn increase the velocity at which the vapor exits the vent toward SiC seed crystal 160. By increasing the amount of vapor flowing through one or more vents such as vent 130, and by alternatively or additionally increasing the velocity of the vapor, the rate of SiC crystal growth may be increased.

The composition of vent 130 may be utilized to further increase the rate of SiC crystal growth. In some embodiments, vent 130 may include a graphite sidewall. For example, one or more of the sidewalls of vent 130 may comprise a graphite material, such as isostatic graphite. Specifically, one or both of inner sidewall 132 and outer sidewall 131 of vent 130 may be implemented with a graphite material such as an isostatic graphite. As vaporized source material travels through vent 130 from source-material region 114 to growth region 112, the vapor may react with the carbon of the graphite material forming one or both of the sidewalls of vent 130. Vent 130 may thus be configured to enrich the vapor from the source-material region 114 with carbon as that vapor passes through vent 130 from source-material region 114 to growth region 112. The enrichment of the vapor with carbon may further increase the rate of SiC crystal growth.

In some embodiments, barrier 118 may be implemented with an isostatic graphite. Isostatic graphite may be less brittle than porous graphite. Thus, the use of isostatic graphite to implement one or both barrier 118 and the sidewalls of vent 130 may improve both the manufacturability and the reliability of crystal growth system 100.

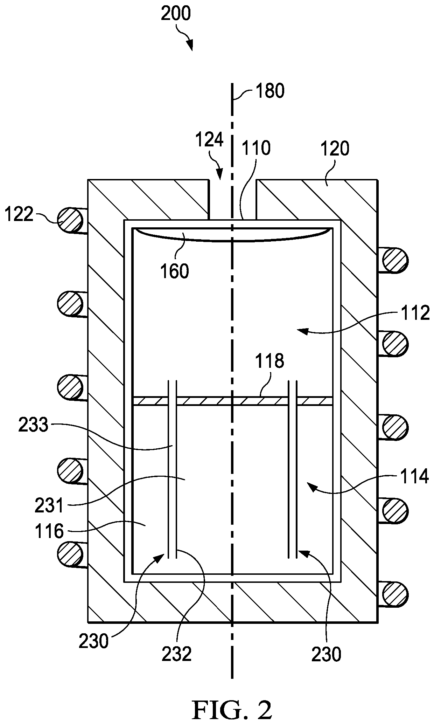

Moreover, in embodiments where a non-porous isostatic graphite is used to implement barrier 118, the vaporized source material may travel from source-material region 114 to growth region 112 solely through the exhaust paths formed by one or more vents such as vent 130. In such embodiments, the growth rate may thereby be more closely controlled by the number and dimensions of one or more vents, such as vent 130, extending from source-material region 114 to growth region 112. As discussed above, and as also discussed below with reference to FIGS. 2-9, the number and dimensions of one or more vents, such as vent 130, may be configured according to the desired projection of vaporized source material toward SiC seed crystal 160 and the corresponding rate of SiC crystal growth.

FIG. 1C illustrates a top view of crystal growth system 150 in accordance with embodiments of the present disclosure. Crystal growth system 150 may include a plurality of vents 135, which may be circular or any other suitable shape, placed in a symmetrical manner around center axis 180. The plurality of vents 135 may collectively serve as an alternative embodiment of vent 130, and may share similar composition and properties as vent 130. In some embodiments, the plurality of vents 135 may share a similar side cross-sectional profile as illustrated for vent 130 in FIG. 1A. But as shown in FIG. 1C, the plurality of vents 135 may be placed in a symmetrical manner along a circle around center axis 180. The plurality of vents 135 may also collectively serve as an alternative embodiment to any of vent 230, vent 330, vent 430, vent 440, or vent 930, described below with reference to FIGS. 2, 3, 4, and 9, and may share a similar side cross-sectional profile as any of vent 230, vent 330, vent 430, vent 440, or vent 930 respectively illustrated in FIGS. 2, 3, 4, and 9.

FIG. 2 illustrates a side cross-sectional view of crystal growth system 200 in accordance with embodiments of the present disclosure. As shown in FIG. 2, crystal growth system 200 may include vent 230. Vent 230 may have an internal space 233 defined between outer sidewall 231 and inner sidewall 232. Vent 230 may be an alternate embodiment of vent 130 shown in FIGS. 1A-1B, and may share similar composition, structure, and properties as vent 130.

The position of vent 230 may be utilized to direct the flow of vapor as desired toward a particular region of SiC seed crystal 160. For example, in the example embodiment of crystal growth system 100 in FIG. 1A, vent 130 may be located closer to the center axis 180 than to the sidewall of crucible 110. In such embodiments, the vaporized source material may be projected by vent 130 toward central portions of SiC seed crystal 160. In the example embodiment of crystal growth system 200 in FIG. 2, vent 230 may be located closer the sidewall of crucible 110 than to the center axis 180 of crucible 110. In such embodiments, the vaporized source material may be projected by vent 130 toward the outer portions of SiC seed crystal 160.

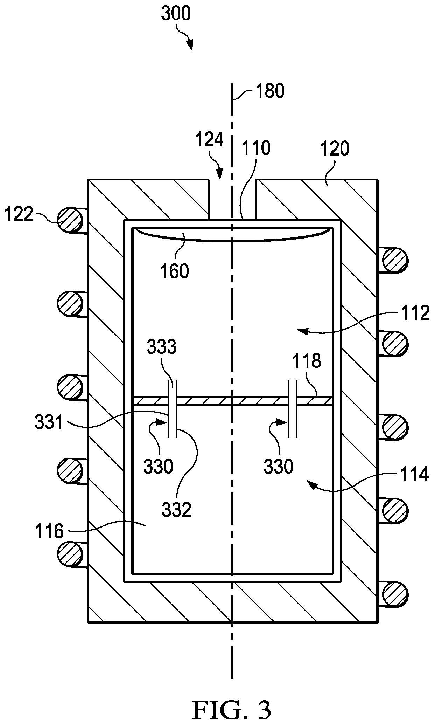

FIG. 3 illustrates a side cross-sectional view of crystal growth system 300 in accordance with embodiments of the present disclosure. As shown in FIG. 3, crystal growth system 300 may include vent 330. Vent 330 may have an internal space 333 defined between outer sidewall 331 and inner sidewall 332. Vent 330 may be an alternate embodiment of vent 130, and may share similar composition, structure, and properties as vent 130.

The height of vent 330 may be utilized to determine the location within source-material region 114 at which vaporized source material enters vent 130. For example, in the example embodiment of crystal growth system 100 in FIG. 1A, vent 130 may extend into source-material region 114 such that a first end of vent 130 may be located within a lower portion of source-material region 114. In the example embodiment of crystal growth system 300 in FIG. 3, vent 330 may extend into source-material region 114 such that the first end of vent 330 may be located within an upper portion of source-material region 114. In either such embodiment, the first end of the vent, whether vent 130 or vent 330, may be located above or proximate to a vertical heat center of crucible 110 within the source-material region 114.

As described above, opening 124 may provide a cooling path through insulation layer 120, and thus together with heating element 122, may generate a temperature gradient within crucible 110 with a decreasing temperature in the direction from source-material region 114 toward opening 124 adjacent to the top of growth region 112. The configuration and placement of the coils of heating element 122 around crucible 110 may determine the location of the hottest vertical point within source-material region 114, also referred to herein as the vertical heat center. In some embodiments, vent 330 may extend into source-material region 114 at a depth such that the first end of vent 330 within source-material region 114 is located above or proximate to the vertical heat center. Such placement of the first end of vent 330 may ensure that the temperature gradient within the internal space 133 of vent 330 is of consistent sign, decreasing in absolute temperature, across the entirety of the distance from the first end of vent 330 located within source-material region 114 to the opposite end of vent 330 located in (or adjacent to) growth region 112. Accordingly, the driving force provided by the temperature gradient within the internal space 333 of vent 330 may consistently project vaporized source material from the source-material region 114 toward SiC seed crystal 160 within growth region 112.

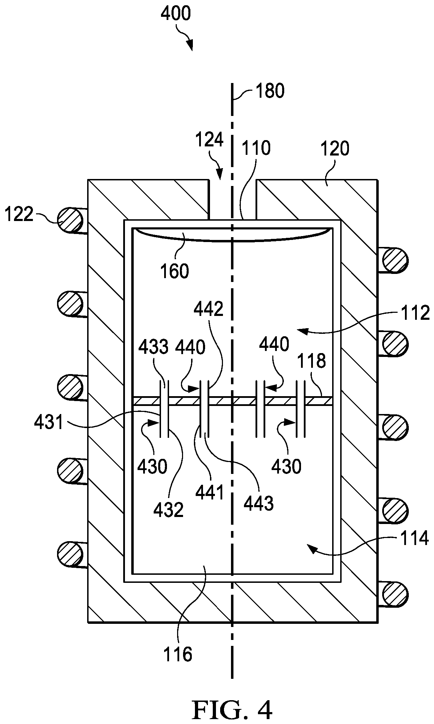

FIG. 4 illustrates a side cross-sectional view of crystal growth system 400 in accordance with embodiments of the present disclosure. In some embodiments, crystal growth system 400 may include a plurality of vents, such as vent 430 and vent 440. Vent 430 may have an internal space 433 defined between inner sidewall 432 and outer sidewall 431. Vent 440 may have an internal space 443 defined between inner sidewall 442 and outer sidewall 441. Vent 430 and vent 440 may be alternate embodiments of vent 130, and may share similar composition, structure, and properties as vent 130.

Each of the plurality of vents, including vent 430 and vent 440, may extend through barrier 118 from the source-material region 114 to the growth region 112. For example, as shown in FIG. 4, vent 430 may extend through barrier 118 from the source-material region 114 to the growth region 112. And as shown in FIG. 4, vent 440 may also extend through barrier 118 from the source-material region 114 to the growth region 112.

Vent 440 may have a thickness, as measured by the distance between inner sidewall 442 and outer sidewall 441, that is greater than, lesser than, or the same as the thickness of vent 430 as measured by the distance between inner sidewall 432 and outer sidewall 431. In some embodiments, vent 430 may be disposed further from center axis 180 than vent 440.

Although the example embodiment of vents 430 and 440 illustrated in FIG. 4 show the respective first ends of vents 430 and 440 extending into source-material region 114 at the same depth, in some embodiments, the first ends of vents 430 and 440 may extend into source-material region 114 at different depths from each other. For both types of embodiments, the respective first ends of the multiple vents may be located above or proximate to the vertical heat center of crucible 110. For example, vent 430 and vent 440 may both extend into source-material region 114 at a depth such that the respective first ends of vents 430 and 440 may be located either above or proximate to the vertical heat center of crucible 110 within the source-material region 114.

The inclusion of more than one vent in crystal growth system 400 may increase the amount of vaporized source material that travels through the total vent space to SiC seed crystal 160. The inclusion of more than one vent in crystal growth system 400 may thus increase the rate of SiC crystal growth. The inclusion of more than one vent in crystal growth system 400 may also provide for a more even spread of the vapor projected by vents 430 and 440 across different regions of SiC seed crystal 160. Accordingly, the inclusion of more than one vent in crystal growth system 400 may provide for a more even growth rate across the inner and outer portions of SiC seed crystal 160. In some embodiments, crystal growth system 400 may include three or more vents. And in some embodiments, the vents may be spaced in a consistent manner relative to each other to further provide an even growth rate across different portions of SiC seed crystal 160.

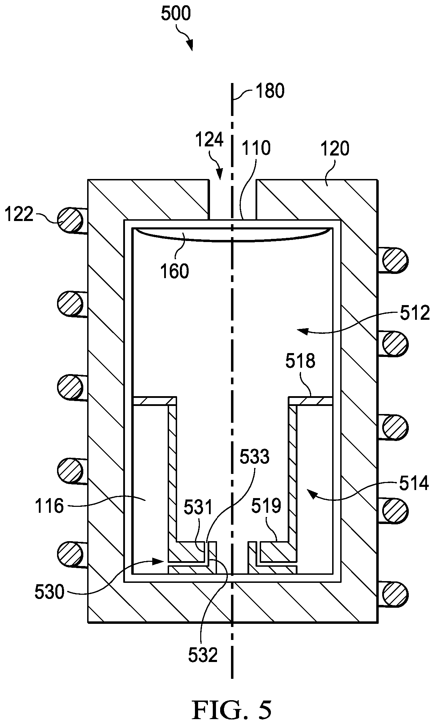

FIG. 5 illustrates a side cross-sectional view of crystal growth system 500 in accordance with embodiments of the present disclosure. As shown in FIG. 5, crystal growth system 500 may include source-material region 514, which may abut the sidewall of crucible 110 along a lower portion of crucible 110. Crystal growth system 500 may also include growth region 512, which may occupy the space within the upper portion of crucible 110 along with the center space in the lower portion of crucible 110 not occupied by source-material region 514.

Crystal growth system 500 may also include barrier 518. Barrier 518 may be located within crucible 110 and configured to separate source-material region 514 and growth region 512. Barrier 518 may be an alternate embodiment of barrier 118, and may share similar composition, structure, and properties as barrier 118. For example, in the same manner as described above for barrier 118 illustrated in FIG. 1A, barrier 518 may comprise either a porous graphite layer or a non-porous isostatic graphite layer. In embodiments where barrier 518 is implemented by a non-porous isostatic graphite layer, the flow of vaporized source material from source-material region 514 toward SiC seed crystal 160 in growth region 512 may be directed solely by vent 530.

As shown in FIG. 5, crystal growth system 500 may also include ventilation support 519. Ventilation support may comprise either a porous graphite layer or a non-porous isostatic graphite layer. In some embodiments, ventilation support 519 may be implemented with a different material than barrier 518. In other embodiments, ventilation support 519 may be implemented with the same material as barrier 518 and may be considered as a portion of barrier 518. For example, in some embodiments, both barrier 518 and ventilation support 519 may be implemented with isostatic graphite.

As shown in FIG. 5, vent 530 may be located within ventilation support 519 and may extend through ventilation support 519 of barrier 518 from source-material region 514 to growth region 512. Vent 530 may have an internal space 533 defined between outer sidewall 531 and inner sidewall 532. And as illustrated by the cross-sectional view of FIG. 5, vent 530 may have an L-type cross-sectional shape extending from source-material region 514 to growth region 512. For example, vent 530 may have a first portion extending horizontally from a first end adjacent to source-material region 514 to an L-curve, and a second portion extending vertically from the L-curve to a second end adjacent to growth region 512.

During crystal growth, heating element 122 may heat the contents of crucible 110, including the SiC source material 116 contained within source-material region 514. When heated, sublimation may occur and the SiC source material 116 may transition from a solid form to a vapor. In a similar manner as described above for FIG. 1A, heating element 122 together with the cooling path formed by opening 124 in insulation layer 120 may provide a temperature gradient with a decreasing temperature in a direction toward opening 124. Accordingly, the vaporized source material may travel through vent 530 and then vertically through growth region 512 toward opening 124 and SiC seed crystal 160 located in the top portion of crucible 110 adjacent to opening 124.

The composition of ventilation support 519 and vent 530 may be utilized to further increase the rate of SiC crystal growth. In some embodiments, vent 530 may include a graphite sidewall. For example, the portions of ventilation support 519 forming the outer sidewall 531 and the inner sidewall 532 of vent 530 may include a graphite material, such as isostatic graphite. As vaporized source material travels through vent 530 from source-material region 514 to growth region 512, the vapor may react with the carbon of the graphite material forming one or both of the sidewalls of vent 530. Vent 530 may thus be configured to enrich the vapor from the source-material region 514 with carbon as that vapor passes through vent 530 from source-material region 514 to growth region 512. The enrichment of the vapor with carbon may further increase the rate of SiC crystal growth.

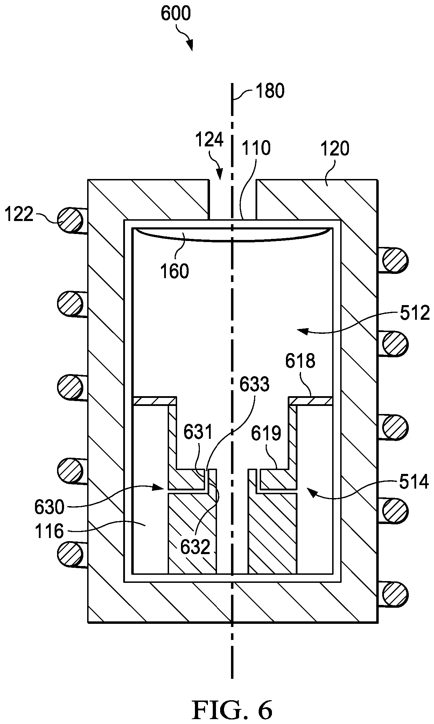

As discussed above, and as also discussed below with reference to FIGS. 6-9, the number and dimensions of one or more vents, such as vent 530, may determine the amount and the velocity of vaporized source material that is projected toward SiC seed crystal 160. Thus, the number and dimensions of one or more vents, such as vent 530, may be configured according to the desired projection of vaporized source material toward SiC seed crystal 160 and the corresponding rate of SiC crystal growth.

FIG. 6 illustrates a side cross-sectional view of crystal growth system 600 in accordance with embodiments of the present disclosure. As shown in FIG. 6, crystal growth system 600 may include barrier 618, ventilation support 619, and vent 630. Vent 630 may have an internal space 633 defined between outer sidewall 631 and inner sidewall 632. Vent 630 may be an alternate embodiment of vent 530, and may share similar composition, structure, and properties as vent 530. Moreover, barrier 618 and ventilation support 619 may be alternate embodiments of barrier 518 and ventilation support 519 respectively, and may share similar composition, structure, and properties as barrier 518 and ventilation support 519 respectively.

The vertical location of vent 630 may be utilized to determine the vertical location within source-material region 514 at which vaporized source material enters vent 630. For example, in the example embodiment of crystal growth system 500 in FIG. 5, vent 530 may be located adjacent to a lower portion of source-material region 514. In the example embodiment of crystal growth system 600 in FIG. 6, vent 630 may be located adjacent to a middle portion of source-material region 514. In other embodiments, vent 630 may be located adjacent to source-material region 514 at any vertical location along the side of source-material region 514 suitable to provide an exhaust path for vaporized source material to exit source-material region 514 and enter growth region 512. In some embodiments, vent 630 may be adjacent to source-material region 514 at a vertical location such that vent 630 is located above or proximate to the vertical heat center of crucible 110.

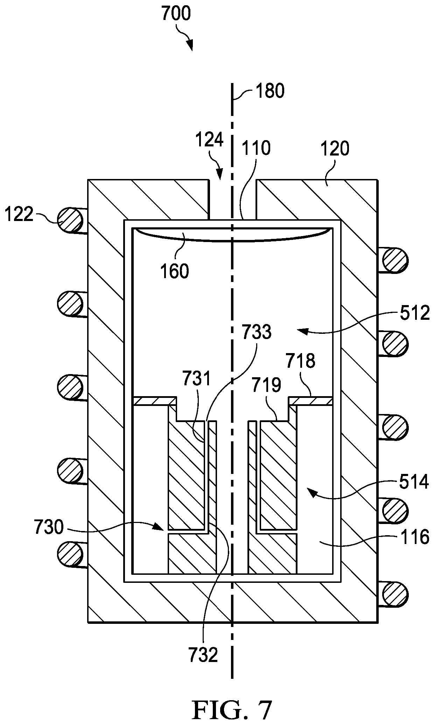

FIG. 7 illustrates a side cross-sectional view of crystal growth system 700 in accordance with embodiments of the present disclosure. As shown in FIG. 7, crystal growth system 700 may include barrier 718, ventilation support 719, and vent 730. Vent 730 may have an internal space 733 defined between outer sidewall 731 and inner sidewall 732. Vent 730 may be an alternate embodiment of vent 530, and may share similar composition, structure, and properties as vent 730. Moreover, barrier 718 and ventilation support 719 may be alternate embodiments of barrier 518 and ventilation support 519 respectively, and may share similar composition, structure, and properties as barrier 518 and ventilation support 519 respectively.

The vertical length of vent 730 may be utilized to determine the velocity at which vaporized source material from source-material region 514 exits vent 730 toward SiC seed crystal 160. In a similar manner as described above for FIG. 1A, opening 124 may provide a cooling path through insulation layer 120, and thus together with heating element 122, may generate a temperature gradient within crucible 110 with a decreasing temperature in the direction from source-material region 514 toward opening 124 adjacent to the top of growth region 112. By increasing the vertical length of vent 730 shown in FIG. 7 relative to, for example, the vertical length of vent 530 shown in FIG. 5, the vertical length of vent 730 may encompass a greater total temperature gradient. The greater total temperature gradient may in turn increase the velocity at which the vapor exits vent 730 toward SiC seed crystal 160. By increasing the velocity of the vapor, the rate of SiC crystal growth may likewise be increased.

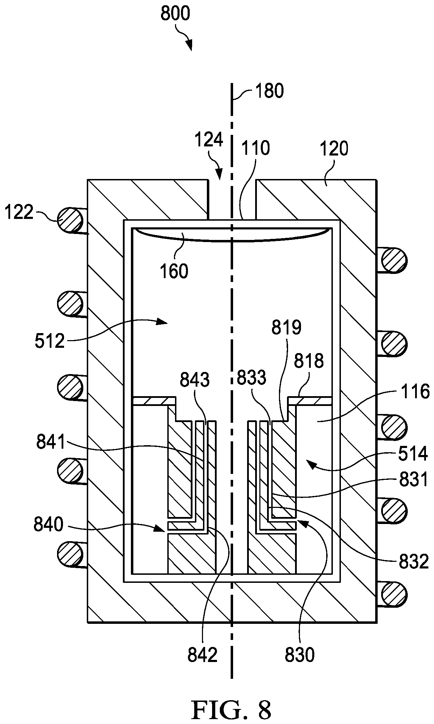

FIG. 8 illustrates a side cross-sectional view of crystal growth system 800 in accordance with embodiments of the present disclosure. As shown in FIG. 8, crystal growth system 800 may include barrier 818, ventilation support 819, and a plurality of vents, such as vent 830 and vent 840. Vent 830 may have an internal space 833 defined between inner sidewall 832 and outer sidewall 831. Vent 840 may have an internal space 843 defined between inner sidewall 842 and outer sidewall 841. Vent 830 and vent 840 may be alternate embodiments of vent 530, and may share similar composition, structure, and properties as vent 530. Moreover, barrier 818 and ventilation support 819 may be alternate embodiments of barrier 518 and ventilation support 519 respectively, and may share similar composition, structure, and properties as barrier 518 and ventilation support 519 respectively.

Each of the plurality of vents, including vent 830 and vent 840, may extend through ventilation support 819 of barrier 818 from the source-material region 514 to the growth region 512. For example, as shown in FIG. 8, vent 830 may extend through ventilation support 819 with an L-type shape from the source-material region 514 to the growth region 512. And as also shown in FIG. 8, vent 840 may extend through ventilation support 819 with an L-type shape from the source-material region 514 to the growth region 512.

The inclusion of more than one vent in crystal growth system 800 may increase the amount of vaporized source material that travels through the total vent space to SiC seed crystal 160. The inclusion of more than one vent in crystal growth system 800 may thus increase the rate of SiC crystal growth. Moreover, in embodiments with multiple vents such as vent 830 and vent 840 of crystal growth system 800, the each of the plurality of vents may be adjacent to source-material region 514 at a vertical location such that each of the plurality of vents is located either above or proximate to the vertical heat center of crucible 110. The inclusion of more than one vent in crystal growth system 800 may also provide for a more even spread of the vapor projected by vents 830 and 840 across different regions of SiC seed crystal 160. Accordingly, the inclusion of more than one vent in crystal growth system 800 may provide for a more even growth rate across the different portions of SiC seed crystal 160.

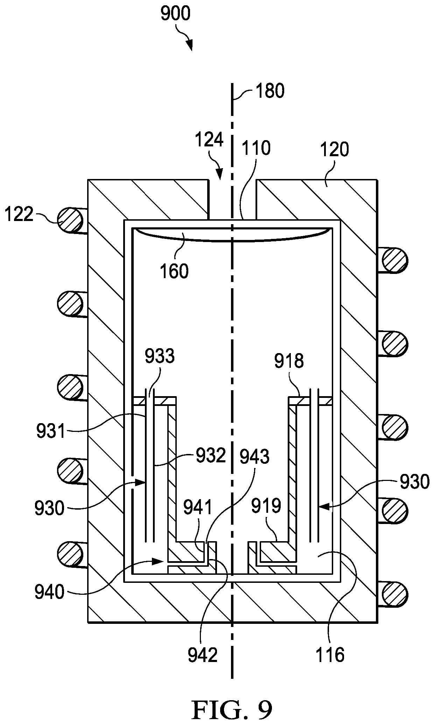

FIG. 9 illustrates a side cross-sectional view of crystal growth system 900 in accordance with embodiments of the present disclosure. As shown in FIG. 9, crystal growth system 900 may include barrier 918, ventilation support 919, and a plurality of vents, such as vent 930 and vent 940. Vent 930 may have an internal space 933 defined between inner sidewall 932 and outer sidewall 931. Vent 940 may have an internal space 943 defined between inner sidewall 942 and outer sidewall 941. As shown in FIG. 9, vent 930 may have a linear cross-sectional shape extending from source-material region 514 to growth region 512. Further, vent 940 may have an L-type cross-sectional shape extending from source-material region 514 to growth region 512. Vent 930 may be an alternate embodiment of vent 130, and may share similar composition, structure, and properties as vent 130. Further, vent 940 may be an alternate embodiment of vent 530, and may share similar composition, structure, and properties as vent 530. Moreover, barrier 918 and ventilation support 919 may be alternate embodiments of barrier 518 and ventilation support 519 respectively, and may share similar composition, structure, and properties as barrier 518 and ventilation support 519 respectively.

As shown in FIG. 9, the plurality of vents may have different shapes. For example, a first of the plurality of vents, such as vent 930, may have a linear cross-sectional shape extending from source-material region 514 to growth region 512. Further, a second of the plurality of vents, such as vent 940, may have an L-type cross-sectional shape extending from source-material region 514 to growth region 512.

The inclusion of more than one vent in crystal growth system 900 may increase the amount of vaporized source material that travels through the total vent space to SiC seed crystal 160. The inclusion of more than one vent in crystal growth system 900 may thus increase the rate of SiC crystal growth. For example, the inclusion of multiple vents, including for example a first vent such as vent 930 with a linear cross-sectional shape, and a second vent such as vent 940 with an L-type cross-sectional shape, may result in a growth rate approximately three times or more larger than that of a crystal growth system with no vents and a porous graphite barrier separating the source-material region and the growth region.

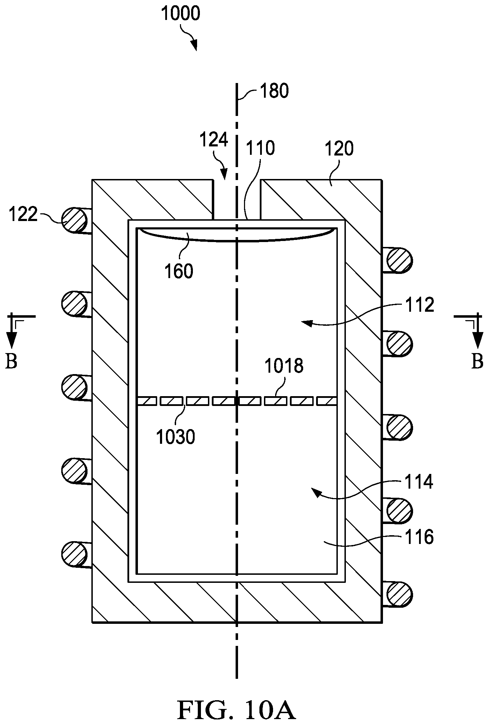

FIG. 10A illustrates a side cross-sectional view of crystal growth system 1000 in accordance with embodiments of the present disclosure. Similar to the example embodiment of crystal growth system 100 illustrated in FIG. 1A, the example embodiment of crystal growth system 1000 in FIG. 10A may include crucible 110 formed around center axis 180, source-material region 114, growth region 112, insulation layer 120, heating element 122, opening 124, SiC source material 116 located within source-material region 114, and SiC seed crystal 160 located within growth region 112.

Crystal growth system 1000 may also include barrier 1018. Barrier 1018 may be configured to separate source-material region 114 and growth region 112. In some embodiments, barrier 1018 may be formed by isostatic graphite. Moreover, barrier 1018 may include a plurality of holes 1030 extending from source-material region 114 on one side of barrier 1018 to growth region 112 on the opposite side of barrier 1018. Each hole 1030 may be formed in barrier 1018 through a suitable machining process (physical drilling, milling, cutting) or any other process suitable for forming holes in barrier 1018. In some embodiments, holes 1030 may be utilized in combination with one or more vents, such as vent 130 illustrated for example in FIG. 1A, extending from source-material region 114 on one side of barrier 1018 to growth region 112 on the opposite side of barrier 1018.

During crystal growth, heating element 122 may heat the contents of crucible 110, including the SiC source material 116 contained within source-material region 114. When heated, sublimation may occur and the SiC source material 116 may transition from a solid form to a vapor. Accordingly, vaporized source material may flow from source-material region 114 and through the plurality of holes 1030 into growth region 112. As described above, heating element 122 together with the cooling path formed by the opening 124 in insulation layer 120 may provide a temperature gradient with a decreasing temperature in the direction from source-material region 114 toward the upper region of growth region 112 adjacent to opening 124. The vaporized source material may thus travel in the direction of the heat gradient toward the SiC seed crystal 160.

The dimensions and number of holes 1030 may be utilized to control the rate of SiC crystal growth. For example, increasing the total area of holes 1030, whether by increasing the number of holes 1030 or by increasing the size of the individual instances of holes 1030, may increase the amount of vapor flowing through holes 1030 and toward SiC seed crystal 160.

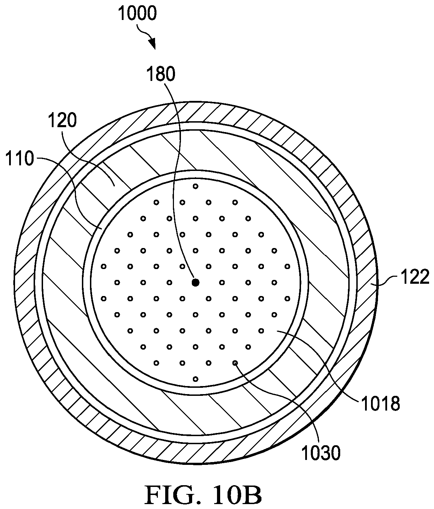

FIG. 10B illustrates a top view of crystal growth system 1000 in accordance with embodiments of the present disclosure. In particular, FIG. 10B illustrates a top view of crystal growth system 1000 from the perspective of cutline B shown FIG. 10A. As shown in FIG. 10A and FIG. 10B, the plurality of holes 1030 may be spread across barrier 1018 on a plane perpendicular to center axis 180.

The spread of holes 1030 across barrier 1018 may provide for a spread of vapor projected from holes 1030 into growth region 112 and may thus control the growth rate across different regions of SiC seed crystal 160. In some embodiments, holes 1030 may be evenly spread across barrier 1018 in order to provide an even spread of the vaporized source material projected from holes 1030 into growth region 112 and toward SiC seed crystal 160. In other embodiments, the concentration of holes 1030 may be varied across different regions of barrier 1018 to separately control amount of vaporized source material projected from holes 1030 into different regions of growth region 112 and toward different regions of SiC seed crystal 160, and to thereby separately control the growth rate across different regions of SiC seed crystal 160.

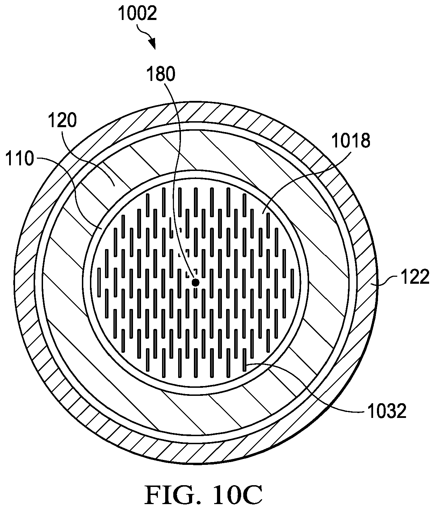

FIG. 10C illustrates a top view of crystal growth system 1002 in accordance with embodiments of the present disclosure. Crystal growth system 1002 may include a plurality of holes 1032. Holes 1032 may serve as an alternative embodiment of holes 1030 described above with reference to FIGS. 10A-B, and may be formed in barrier 1018 in a similar manner as described above for holes 1030. As shown in FIG. 10C, each of the plurality of holes 1032 may have a slit shape and may be arranged in an even manner throughout the area of barrier 1018.

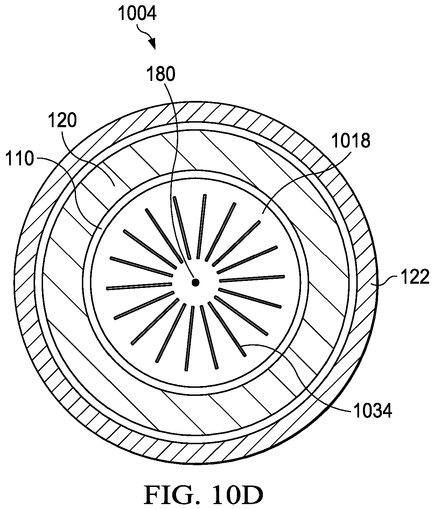

FIG. 10D illustrates a top view of crystal growth system 1004 in accordance with embodiments of the present disclosure. Crystal growth system 1004 may include a plurality of holes 1034. Holes 1034 may serve as an alternative embodiment of holes 1030 described above with reference to FIGS. 10A-B, and may be formed in barrier 1018 in a similar manner as described above for holes 1030. As shown in FIG. 10D, each of the plurality of holes 1034 may have a slit shape extending inward toward center axis 180 and extending outward toward the inner wall of crucible 110. In some embodiments, the plurality of holes 1034 may be spaced in a radially symmetric manner about center axis 180.

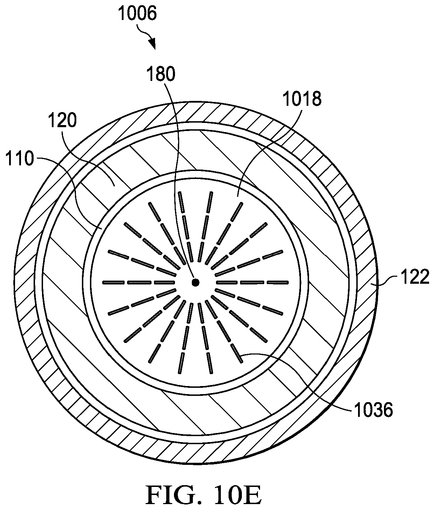

FIG. 10E illustrates a top view of crystal growth system 1006 in accordance with embodiments of the present disclosure. Crystal growth system 1006 may include a plurality of holes 1036. Holes 1036 may serve as an alternative embodiment of holes 1030 described above with reference to FIGS. 10A-B, and may be formed in barrier 1018 in a similar manner as described above for holes 1030. As shown in FIG. 10E, each of the plurality of holes 1036 may have a slit shape extending inward toward center axis 180 and extending outward toward the inner wall of crucible 110. As also shown in FIG. 10E, a grouping of multiple holes 1036, for example three instances of holes 1036, may be placed along a linear path pointing inward toward the center axis 180 and outward toward the inner wall of crucible 110. Moreover, different groupings of the plurality of holes 1036 may be spaced in a radially symmetric manner about center axis 180.

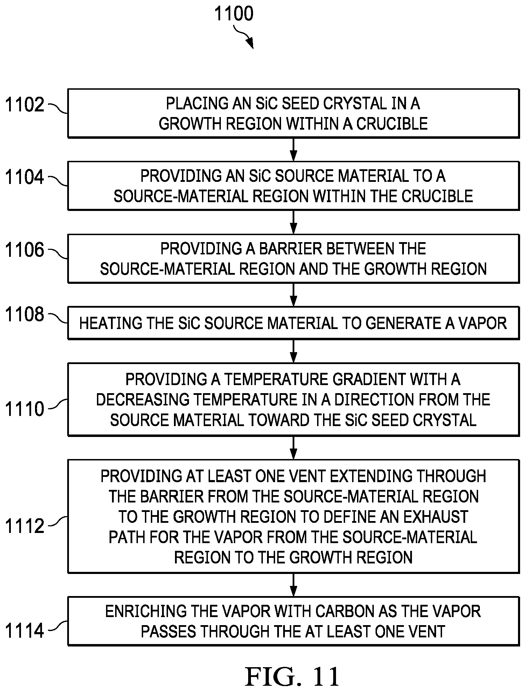

FIG. 11 illustrates method 1100 for growing an SiC crystal in accordance with embodiments of the present disclosure. Method 1100 may be performed by any suitable mechanism, including the component parts of crystal growth systems 100, 150, 200, 300, 400, 500, 600, 700, 800, 900, 1000, 1002, 1004, or 1006. Method 1100 may be performed with fewer or more steps than shown in FIG. 11. Moreover, steps of method 1100 may be omitted, repeated, performed in parallel, performed in a different order than shown in FIG. 11, or performed recursively. One or more steps of method 1100, although shown in an order, may be performed at the same time or in a re-ordered manner.

Step 1102 may include placing an SiC seed crystal in a growth region within a crucible. For example, SiC seed crystal 160 may be placed in growth region 112.

Step 1104 may include providing an SiC source material to a source-material region within the crucible. For example, SiC source material 116 may be provided to source-material region 114 within crucible 110.

Step 1106 may include providing a barrier between the source-material region and the growth region. For example, barrier 118 may be provided between source-material region 114 and growth region 112 within crucible 110.

Step 1108 may include heating the SiC source material to generate a vapor. For example, heating element 122 may heat the contents of crucible 110 including SiC source material 116 within source-material region 114. The heating may cause sublimation of SiC source material 116 thereby generating a vapor in the form of vaporized source material.

Step 1110 may include providing a temperature gradient with a decreasing temperature in a direction from the source material toward the SiC seed crystal. For example, as described above with reference to FIG. 1A, opening 124 may provide a cooling path through insulation layer 120. Heating element 122 and opening 124 together may thus generate a temperature gradient within crucible 110 with a decreasing temperature in the direction from the SiC source material 116 in source-material region 114 toward the SiC seed crystal 160 located in a portion of growth region 112 adjacent to opening 124.

Step 1112 may include providing at least one vent extending through the barrier from the source-material region to the growth region to define an exhaust path for the vapor from the source-material region to the growth region. For example, a vent such as vent 130 may be provided. As shown in FIG. 1A, vent 130 may extend through barrier 118 from source-material region 114 to growth region 112. As another example, a vent such as vent 530 may be provided. Vent 530 may extend through ventilation support 519 of barrier 518 from source-material region 514 to growth region 512.

Step 1114 may include enriching the vapor with carbon as the vapor passes through the at least one vent from the source-material region to the growth region. For example, as described above with reference to FIG. 1 A, one or more of the sidewalls of vent 130 may comprise a graphite material, such as isostatic graphite. Specifically, one or both of inner sidewall 132 and outer sidewall 131 of vent 130 may be implemented with a graphite material such as an isostatic graphite. As vaporized source material travels through vent 130 from source-material region 114 to growth region 112, the vapor may react with the carbon of the graphite material forming one or both of the sidewalls of vent 130. Vent 130 may thus be configured to enrich the vapor from the source-material region 114 with carbon as that vapor passes through vent 130 from source-material region 114 to growth region 112.

Embodiments herein may include a growth system. The growth system includes a crucible at least partially enclosed by an insulation layer, and a growth region located within the crucible and configured to hold a silicon carbide (SiC) seed crystal. The growth system further includes a source-material region located within the crucible and configured to hold an SiC source material. In addition, the growth system includes a barrier located within the crucible and configured to separate the source-material region and the growth region. Further, the growth system includes a heating element located around the crucible and configured together with an opening in the insulation layer to provide a temperature gradient with a decreasing temperature in a direction from the source material toward the growth region. In addition, the growth system includes a vent extending through the barrier from the source-material region to the growth region.

The growth system may also have one or more of the following additional elements in any combination. Element 1: wherein the barrier comprises isostatic graphite. Element 2: wherein the growth system further comprises a plurality of holes extending through the barrier from the source-material region to the growth region. Element 3: wherein the barrier comprises porous graphite. Element 4: wherein the vent includes a graphite sidewall is configured to enrich a vapor from the source-material region with carbon as the vapor passes through the vent from the source-material region to the growth region. Element 5: wherein the vent comprises isostatic graphite. Element 6: wherein the vent has an inner sidewall with a first cylindrical shape centered around a center axis of the crucible and an outer sidewall with a second cylindrical shape centered around the center axis of the crucible, the first cylindrical shape having a first diameter smaller than a second diameter of the second cylindrical shape. Element 7: wherein a first end of the vent is located proximate to a vertical heat center of the crucible within the source-material region and a second end of the vent extends into the growth region. Element 8: wherein the vent has a linear cross-sectional shape extending from the source-material region to the growth region. Element 9: wherein the vent has an L-type cross-sectional shape extending from the source-material region to the growth region. Element 10: wherein the growth system includes a plurality of vents, and each of the plurality of vents extends through the barrier from the source-material region to the growth region. Element 11: wherein each of a first and a second of the plurality of vents has a linear cross-sectional shape extending from the source-material region to the growth region. Element 12: wherein each of a first and a second of the plurality of vents has an L-type cross-sectional shape extending from the source-material region to the growth region. Element 13: wherein a first of the plurality of vents has a linear cross-sectional shape extending from the source-material region to the growth region, and a second of the plurality of vents has an L-type cross-sectional shape extending from the source-material region to the growth region.

Embodiments herein may include a growth system. The growth system includes a crucible at least partially enclosed by an insulation layer, and a growth region located within the crucible and configured to hold a silicon carbide (SiC) seed crystal. The growth system further includes a source-material region located within the crucible and configured to hold an SiC source material. In addition, the growth system includes a barrier located within the crucible and configured to separate the source-material region and the growth region. The growth system further includes a heating element located around the crucible and configured together with an opening in the insulation layer to provide a temperature gradient with a decreasing temperature in a direction from the source material toward the growth region. In addition, the growth system includes a plurality of holes extending through the barrier from the source-material region to the growth region. The growth system may further have the following additional element. Element 1: wherein the barrier comprises isostatic graphite.

Embodiments herein may include a method for controlling silicon carbide (SiC) crystal growth. The method may include placing an SiC seed crystal in a growth region within a crucible, providing an SiC source material to a source-material region within the crucible, providing a barrier between the source-material region and the growth region, heating the SiC source material to generate a vapor, providing a temperature gradient with a decreasing temperature in a direction from the source material toward the SiC seed crystal, and providing at least one vent extending through the barrier from the source-material region to the growth region to define an exhaust path for the vapor from the source-material region to the growth region.

The method may also have one or more of the following additional elements in any combination. Element 1: wherein the barrier comprises isostatic graphite. Element 2: wherein the barrier further comprises a plurality of holes extending through the barrier from the source-material region to the growth region. Element 3: enriching the vapor with carbon as the vapor passes through the at least one vent from the source-material region to the growth region.

Although examples have been described herein with reference to vertical position, depth, or height, with the vertical direction being parallel to the direct of center axis 180, the disclosure is not so limited. For example, in embodiments where the positioning of crucible 110 and the components therein are rotated 90 degrees such that center axis 180 is horizontal instead of vertical, the reference herein to vertical dimensions or locations may equally apply to horizontal dimensions or locations.

Although examples have been described above, other modifications and variations may be made from this disclosure without departing from the spirit and scope of these examples. The above descriptions of various embodiments illustrate the principles of the invention. Numerous variations and modifications will become apparent to those skilled in the art based on the above disclosure. The following claims are intended to embrace all such variations and modifications.

## Claims

1. A growth system, comprising:
a crucible at least partially enclosed by an insulation layer;
a growth region located within the crucible and configured to hold a silicon carbide (SiC) seed crystal;
a source-material region located within the crucible and configured to hold an SiC source material;
a barrier located within the crucible and configured to separate the source-material region and the growth region;
a heating element located around the crucible and configured together with an opening in the insulation layer to provide a temperature gradient with a decreasing temperature in a direction from the source material toward the growth region; and
a vent extending through the barrier from the source-material region to the growth region.

2. The growth system of claim 1, wherein the barrier comprises isostatic graphite.

3. The growth system of claim 1, further comprising a plurality of holes extending through the barrier from the source-material region to the growth region.

4. The growth system of claim 1, wherein the vent includes a graphite sidewall is configured to enrich a vapor from the source-material region with carbon as the vapor passes through the vent from the source-material region to the growth region.

5. The growth system of claim 4, wherein the vent comprises isostatic graphite.

6. The growth system of claim 1, wherein a first end of the vent is located proximate to a vertical heat center of the crucible within the source-material region and a second end of the vent extends into the growth region.

7. The growth system of claim 1, wherein the vent has a linear cross-sectional shape extending from the source-material region to the growth region.

8. The growth system of claim 1, wherein the vent has an L-type cross-sectional shape extending from the source-material region to the growth region.

9. The growth system of claim 1, wherein:
the growth system includes a plurality of vents; and
each of the plurality of vents extends through the barrier from the source-material region to the growth region.

10. A growth system, comprising:
a crucible at least partially enclosed by an insulation layer;
a growth region located within the crucible and configured to hold a silicon carbide (SiC) seed crystal;
a source-material region located within the crucible and configured to hold an SiC source material;
a barrier located within the crucible and configured to separate the source-material region and the growth region;
a heating element located around the crucible and configured together with an opening in the insulation layer to provide a temperature gradient with a decreasing temperature in a direction from the source material toward the growth region; and
a plurality of holes extending through the barrier from the source-material region to the growth region.

11. The growth system of claim 10, wherein the barrier comprises isostatic graphite.

12. A method for controlling silicon carbide (SiC) crystal growth:
placing an SiC seed crystal in a growth region within a crucible;
providing an SiC source material to a source-material region within the crucible;
providing a barrier between the source-material region and the growth region;
heating the SiC source material to generate a vapor;
providing a temperature gradient with a decreasing temperature in a direction from the source material toward the SiC seed crystal; and
providing at least one vent extending through the barrier from the source-material region to the growth region to define an exhaust path for the vapor from the source-material region to the growth region.

13. The method of claim 12 wherein the barrier comprises isostatic graphite.

14. The method of claim 13, wherein the barrier further comprises a plurality of holes extending through the barrier from the source-material region to the growth region.

15. The method of claim 13, further comprising enriching the vapor with carbon as the vapor passes through the at least one vent from the source-material region to the growth region.

## Amended claims

### Amended claims in accordance with Rule 137(2) EPC.

1. A growth system (100, 150, 200, 300, 400, 500, 600, 700, 800, 900, 1000, 1002, 1004, 1006), comprising:
a crucible (110) at least partially enclosed by an insulation layer (120);
a growth region (112, 512) located within the crucible (110) and configured to hold a silicon carbide (SiC) seed crystal (160);
a source-material region (114, 514) located within the crucible (110) and configured to hold an SiC source material (116);
a barrier (118, 518, 618, 718, 818, 918, 1018) located within the crucible (110) and configured to separate the source-material region (114, 514) and the growth region (112, 512);
a heating element (122) located around the crucible (110) and configured, together with an opening in the insulation layer (120), to provide a temperature gradient with a decreasing temperature in a direction from the source material (116) toward the growth region (112, 512); and
a vent (130, 230, 330, 430, 530, 630, 730, 830, 930) extending through the barrier (118, 518, 618, 718, 818, 918, 1018) from the source-material region (114, 514) to the growth region (112, 512),
**characterized in that**
the barrier (118, 518, 618, 718, 818, 918, 1018) comprises isostatic graphite.

2. The growth system (100, 150, 200, 300, 400, 500, 600, 700, 800, 900, 1000, 1002, 1004, 1006) of claim 1, further comprising a plurality of holes (1030, 1032, 1034, 1036) extending through the barrier (118, 518, 618, 718, 818, 918, 1018) from the source-material region (114, 514) to the growth region (112, 512).

3. The growth system (100, 150, 200, 300, 400, 500, 600, 700, 800, 900, 1000, 1002, 1004, 1006) of claim 1, wherein the vent (130, 230, 330, 430, 530, 630, 730, 830, 930) includes a graphite sidewall (132, 232, 332, 432, 532, 632, 732, 832, 932) which is configured to enrich a vapor from the source-material region (114, 514) with carbon as the vapor passes through the vent (130, 230, 330, 430, 530, 630, 730, 830, 930) from the source-material region (114, 514) to the growth region (112, 512).

4. The growth system (100, 150, 200, 300, 400, 500, 600, 700, 800, 900, 1000, 1002, 1004, 1006) of claim 3, wherein the vent (130, 230, 330, 430, 530, 630, 730, 830, 930) comprises isostatic graphite.

5. The growth system (100, 150, 200, 300, 400, 500, 600, 700, 800, 900, 1000, 1002, 1004, 1006) of claim 1, wherein a first end of the vent (130, 230, 330, 430, 530, 630, 730, 830, 930) is located proximate to a vertical heat center of the crucible (110) within the source-material region (114, 514) and a second end of the vent (130, 230, 330, 430, 530, 630, 730, 830, 930) extends into the growth region (112, 512).

6. The growth system (100, 150, 200, 300, 400, 500, 600, 700, 800, 900, 1000, 1002, 1004, 1006) of claim 1, wherein the vent (130, 230, 330, 430, 530, 630, 730, 830, 930) has a linear cross-sectional shape extending from the source-material region (114, 514) to the growth region (112, 512).

7. The growth system (100, 150, 200, 300, 400, 500, 600, 700, 800, 900, 1000, 1002, 1004, 1006) of claim 1, wherein the vent (130, 230, 330, 430, 530, 630, 730, 830, 930) has an L-type cross-sectional shape extending from the source-material region (114, 514) to the growth region (112, 512).

8. The growth system (100, 150, 200, 300, 400, 500, 600, 700, 800, 900, 1000, 1002, 1004, 1006) of claim 1, wherein:
the growth system (100, 150, 200, 300, 400, 500, 600, 700, 800, 900, 1000, 1002, 1004, 1006) includes a plurality of vents (130, 230, 330, 430, 530, 630, 730, 830, 930); and
each of the plurality of vents (130, 230, 330, 430, 530, 630, 730, 830, 930) extends through the barrier (118, 518, 618, 718, 818, 918, 1018) from the source-material region (114, 514) to the growth region (112, 512).

9. A method for controlling silicon carbide (SiC) crystal growth comprising:
placing an SiC seed crystal (160) in a growth region (112, 512) within a crucible (110);
providing an SiC source material (116) to a source-material region (114, 514) within the crucible (110);
providing a barrier (118, 518, 618, 718, 818, 918, 1018) between the source-material region (114, 514) and the growth region (112, 512);
heating the SiC source material (116) to generate a vapor;
providing a temperature gradient with a decreasing temperature in a direction from the source material (116) toward the SiC seed crystal (160); and
providing at least one vent (130, 230, 330, 430, 530, 630, 730, 830, 930) extending through the barrier (118, 518, 618, 718, 818, 918, 1018) from the source-material region (114, 514) to the growth region (112, 512) to define an exhaust path for the vapor from the source-material region (114, 514) to the growth region (112, 512),
**characterized in that**
the barrier (118, 518, 618, 718, 818, 918, 1018) comprises isostatic graphite.

10. The method of claim 9, wherein the barrier (118, 518, 618, 718, 818, 918, 1018) further comprises a plurality of holes (1030, 1032, 1034, 1036) extending through the barrier (118, 518, 618, 718, 818, 918, 1018) from the source-material region (114, 514) to the growth region (112, 512).

11. The method of claim 9, further comprising enriching the vapor with carbon as the vapor passes through the at least one vent (130, 230, 330, 430, 530, 630, 730, 830, 930) from the source-material region (114, 514) to the growth region (112, 512).
